Europäisches Patentamt

European Patent Office

Office européen des brevets

(19)

(11) EP 0 881 775 A1

(12) EUROPEAN PATENT APPLICATION

(43) Date of publication:
02.12.1998 Bulletin 1998/49

(51) Int. Cl.$^6$: H03L 7/183, G06F 1/08

(21) Application number: 98109540.9

(22) Date of filing: 26.05.1998

(84) Designated Contracting States:
AT BE CH CY DE DK ES FI FR GB GR IE IT LI LU
MC NL PT SE
Designated Extension States:
AL LT LV MK RO SI

(30) Priority: 30.05.1997 JP 156113/97

(71) Applicant: NEC CORPORATION
Tokyo (JP)

(72) Inventor:
Kawamura, Takahiro,
NEC IC Microcomputer Syst. Ltd
Kawasaki-shi, Kanagawa (JP)

(74) Representative: Betten & Resch
Reichenbachstrasse 19
80469 München (DE)

(54) A clock generator

(57) To provide a clock generator wherein output clock frequency can be selected with sufficiently fine steps without needing no higher frequency than the output clock frequency for contributing to high performance and low power consumption as well of IC chips, a clock generator comprises a PLL circuit (3, 4, 5 and 6) for generating an output clock signal by frequency-multiplying a reference clock signal, a variable frequency divider (2) for obtaining the reference clock signal to be supplied to the PLL circuit by frequency-dividing an input clock signal; and a control means (7) for selectively controlling a frequency dividing ratio of the variable frequency divider (2).

## FIG. 1

## Description

The present invention relates to a clock generator whereof a clock frequency can be determined selectively.

Recently, operational frequency of semiconductor IC (Integrated Circuit) chips such as a microcomputer chip is made high, and it has become difficult to supply clock signals having the same frequency with the operational frequency of the semiconductor IC chips from outside of the semiconductor IC chips.

Therefore, in many IC chips, there is provided a frequency multiplier circuit making use of PLL (Phase Lock Loop) circuit, for example, for generating a high frequency clock signal used therein by multiplying a comparatively low frequency clock signal which is supplied from external circuit.

As an example of the frequency multiplier circuit for this purpose, there is a prior art disclosed in a Japanese patent application laid open as a Provisional Publication No. 93126/'97, entitled "Clock Generator".

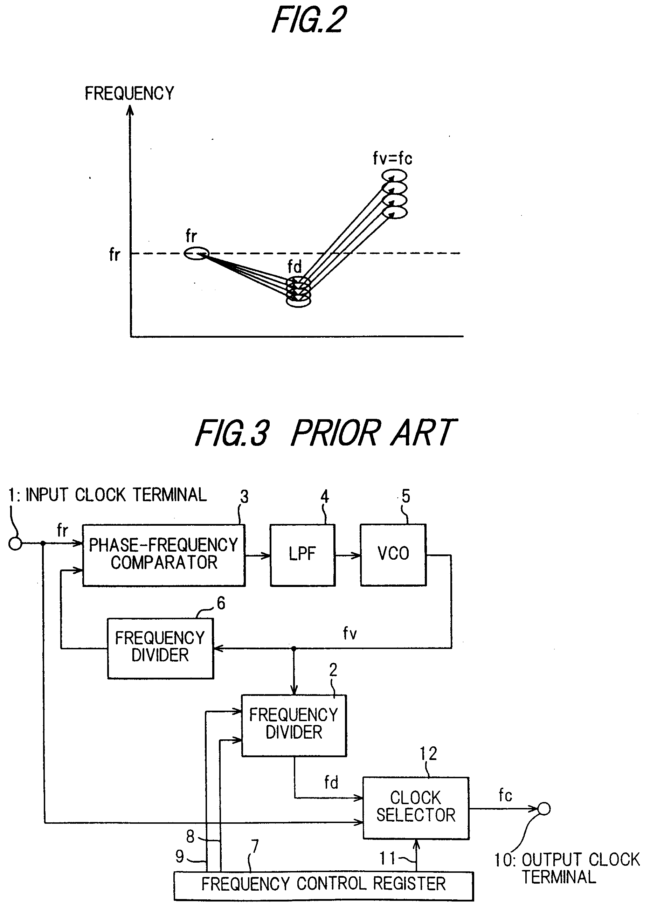

FIG. 3 is a block diagram illustrating the clock generator of the above prior art.

Referring to FIG. 3, an input clock signal having a frequency $fr$ is supplied from a crystal oscillator or an external circuit (not depicted in the drawings), which is input to a phase-frequency comparator 3 as a reference clock signal and also to a clock selector 12.

Output of the phase-frequency comparator 3 is filtered by an LPF (Low Pass Filter) 4 and supplied to a VCO (Voltage Controlled Oscillator) 5 for controlling an output frequency $fv$ of the VCO 5. The output of the VCO 5 is supplied to a first and a second frequency divider 6 and 2. Output of the first, frequency divider 6 is fed back to the phase-frequency comparator 3 to be compared to the reference clock signal, that is, the input clock signal.

Frequency dividing rate of the second frequency divider 2 is controlled selectively according to logic of frequency dividing control signals 8 and 9 which are output from a frequency control register 7. The frequency control register 7 also outputs a clock selector signal 11 to be supplied to the clock selector 12 for selecting an output clock signal of an output clock terminal 10 having a frequency $fc$ from either the input clock signal of the frequency $fr$ or the output of the second frequency divider 2 having a frequency $fd$.

The phase-frequency comparator 3, the LPF 4, the VCO 5 and the first frequency divider 6 compose an feedback loop and operate as a PLL circuit for locking the frequency and tile phase of output of the first frequency divider 6 to be synchronized with those of the input clock signal of the frequency $fr$. Therefore, relation between the frequency $fr$ of the input clock signal and the output frequency $fv$ of the VCO 5 is represented by an equation $fv = M \cdot fr$, where $M$ is a positive integer denoting the frequency dividing ratio of the first frequency divider 6.

On the other hand, relation between the output frequency $fv$ of the VCO 5 and the output frequency $fd$ of the second frequency divider 2 is represented by $fd = fv/N$, $N$ being the frequency dividing ratio of the second frequency divider 2, which is a positive integer selectively determined according to logic of the frequency dividing control signals 8 and 9. The frequency $fc$ of the output clock signal is determined by the clock selector signal 11 to be either the frequency $fr$ of the input signal or the output frequency $fd$ of the second frequency divider 2, that is, $fc = fr$ or $fd = fr \cdot M/N$.

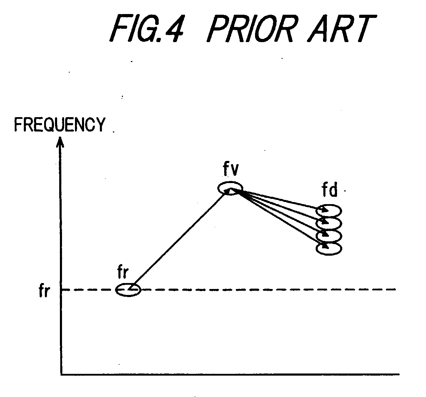

FIG. 4 is a graphic chart schematically illustrating relation among the frequency $fr$ of the input clock signal, the output frequency $fv$ of the VCO 5 and the output frequency $fd$ of the second frequency divider 2. As shown in FIG. 4, the highest frequency in the clock generator of the prior is the output frequency $fv = M \cdot fr$ of the VCO 5, which remains constant independently of the frequency dividing ratio $N$ of the second frequency divider 2.

Thus, the clock generator of the prior art generates an output clock signal having the frequency $fc$, which can be changed stably at once by controlling the frequency dividing control signals 8 and 9 or the clock selector signal 11.

However, when the operational frequency of the IC chips becomes still higher, there arise problems in the clock generator of the prior art.

That is, harmonic noises of the output frequency $fv$ of the VCO 5 may cause interference in the IC chips, because tile output frequency $fv$ of the VCO 5 should be $N$ times higher than the output clock frequency $fc$, namely, the operational frequency of the IC chips. Furthermore, this frequency dividing ratio $N$ of the second frequency divider 2 should be sufficiently large for defining steps of selectable values of the output clock frequency $fc$ sufficiently finely.

Therefore, fine setting of the selectable frequency value may require the output frequency $fv, = N \cdot fc$ of the VCO 5 higher than the operational frequency limit of the frequency dividers, not only magnifying the above problem.

Therefore, a primary object of the present invention is to provide a clock generator wherein output clock frequency can be selected with sufficiently fine steps without needing no higher frequency than the output clock frequency for contributing to high performance and low power consumption as well, of the IC chips.

In order to achieve the object, a clock generator of the invention comprises:

a PLL circuit for generating an output clock signal by frequency-multiplying a reference clock signal;
a variable frequency divider for obtaining the reference clock signal to be supplied to the PLL circuit by frequency-dividing all input clock signal; and
a control means for selectively controlling a frequency dividing ratio of the variable frequency divider.

The PLL circuit comprises:

a phase-frequency comparator for comparing a frequency and a phase of a feedback signal to those of the reference clock signal;
an LPF for extracting low frequency component from output of the phase-frequency comparator;
a VCO for generating the output clock signal of a frequency according to the output of the LPF; and
a frequency divider for obtaining the feedback signal to be supplied to the phase-frequency comparator by frequency-dividing the output clock signal.

The control means comprises:

a frequency control register for determining logic of frequency control signals for defining the frequency dividing ratio of the variable frequency divider; and
a means for controlling the frequency control register according to desired operational speed of a circuit where the output clock signal is supplied.

Therefore, the output clock signal having an appropriate frequency for each intended operation of the IC chip, for example, can be obtained by selectively controlling the frequency dividing ratio in accordance with the intended operation of the IC chip, and desired frequency steps of the output clock signal can be set by appropriately designing the frequency dividing ratios of the variable frequency divider and the frequency divider of the PLL, without needing any higher frequency than the desired operational frequency of the IC chips.

The foregoing, further objects, features, and advantages of this invention will become apparent from a consideration of the following description, the appended claims, and the accompanying drawings wherein the same numerals indicate the same or the corresponding parts.

In the drawings:

FIG. 1 is a block diagram illustrating a clock generator according to an embodiment of the invention;
FIG. 2 is a graphic chart schematically illustrating relation among the frequency $fr$ of the input clock signal, the reference frequency $fd$ supplied to the phase-frequency comparator 3 of the PLL circuit and the output frequency $fv$ of the VCO 5 of the PLL circuit of FIG. 1;
FIG. 3 is a block diagram illustrating a clock generator of a prior art; and
FIG. 4 is a graphic chart schematically illustrating relation among the frequency $fr$ of the input clock signal, the output frequency $fv$ of the VCO 5 and the output frequency $fd$ of the second frequency divider 2 of FIG. 3.

Now, embodiments of the present invention will be described in connection with the drawings.

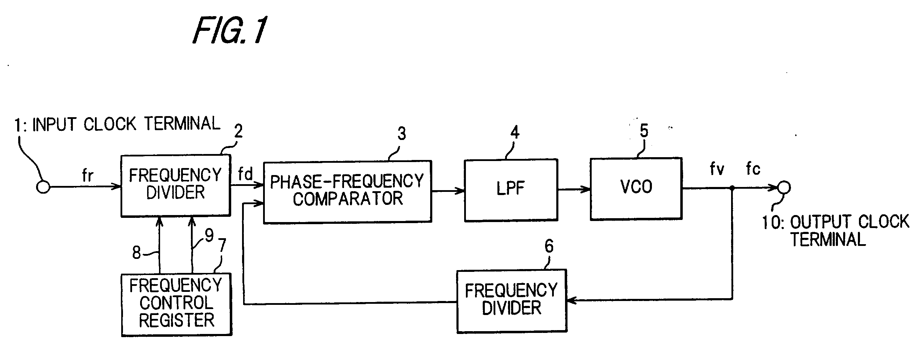

FIG. 1 is a block diagram illustrating a clock generator according to an embodiment of the invention.

Referring to FIG. 1, the clock generator of the embodiment comprises;

a PLL circuit including a phase-frequency comparator 3, an LPF 4, a VCO 5 and a first frequency divider 6,
a second frequency divider 2 for outputting a reference clock signal having a frequency $fd$ to be supplied to the phase-frequency comparator 3 by frequency-dividing an input clock signal of a frequency $fr$ supplied through an input clock terminal 1 from a crystal oscillator or an external circuit (both not depicted in the drawings), and
a frequency control register 7 for outputting frequency dividing control signals 8 and 9 for controlling frequency dividing ratio of the second frequency divider 2.

Therefore, the reference frequency $fd$ of the PLL circuit is controlled to be $fd = fr/N$, where $N$ is a frequency dividing ratio of the second frequency divider 2, which is a positive integer selevtively determined by the frequency control signals 8 and 9, in the embodiment.

The PLL circuit operates in the same way with that of the prior art of FIG. 3.

The output of the phase-frequency comparator 3 is filtered by the LPF 4 to be supplied to tile VCO 5 for controlling output frequency $fv$ of the VCO 5. The output frequency $fv$ of the VCO 5 is frequency-divided by the first frequency divider 6 to be fed back to the phase-frequency comparator 3 to be compared with the reference clock signal having the frequency $fd$, wherewith tile frequency and the phase of the output of the first frequency divider 6 is locked to be synchronized.

In the embodiment, the output of the VCO 5 is directly connected to an output clock terminal 10 for supplying an output clock signal of a frequency $fc$ which is the same with the output frequency $fv$ of the VCO 5.

Therefore, the output clock frequency $fc$ becomes $fc = M \cdot fd = fr \cdot M/N$, $M$ being a positive integer representing the frequency dividing ratio of the first frequency divider.

FIG. 2 is a graphic chart schematically illustrating relation among the frequency $fr$ of the input clock signal, the reference frequency $fd$ supplied to the phase-frequency comparator 3 of the PLL circuit and the output frequency $fv$ of the VCO 5 of the PLL circuit, which is the same with the output clock frequency $fc$.

The output clock frequency $fc = fr \cdot M/N$ is obtained by the clock generator of the embodiment, similarly to the prior art of FIG 3. However, the highest frequency, that is, the output frequency $fv$ of the VCO 5 of the PLL circuit remains to be the same with the output clock frequency $fc$ as shown in FIG. 2, in the embodiment, on condition that $M$ is not smaller than $N$.

In other words, there is needed no frequency higher than that of the input clock signal or the output clock signal, however finely the frequency steps to be selected is defined, in the clock generator according to the embodiment.

In the following paragraphs, a concrete example of the embodiment will be described.

Suppose that an input clock signal of 10 MHz is supplied to the input clock terminal 1 and that the frequency dividing ratio $N$ of the second frequency divider is controlled to be $N = 8, 9, 10$ and 11, when logic of the frequency control signals 8 and 9 is (0, 0), (0, 1), (1, 0) and (1, 1), respectively.

Then, the reference frequency $fd$ supplied to the PLL circuit becomes 1.25 MHz ($N = 8$), 1.11 MHz ($N = 9$), 1.00 MHz ($N = 10$) and 0.90MHz ($N = 11$), respectively.

Therefore, when the frequency dividing ratio $M$ of the first frequency divider 6 is $M = 64$, the output frequency $fv$ of the VCO 5 becomes 80MHz ($M = 64, N = 8$), 71MHz ($M = 64, N = 9$), 64MHz ($M = 64, N = 10$) and 58MHz ($M = 64, N = 11$), respectively.

Thus, the output clock signal having an appropriate frequency for each intended operation of the IC chip can be obtained by changing logic of the frequency dividing control signals 8 and 9 of the frequency control register 7 by a CPU (not depicted in the drawings,) for example, in accordance with the intended operation of tile IC chip, with the clock generator of the embodiment. Therefore, the operational frequency of the IC chip may be lowered, for example, for reducing power consumption when a high operational speed is not necessary.

Further, desired frequency steps of the output clock signal can be set by appropriately designing the frequency dividing ratios $M$ and $N$ of the first and the second frequency divider 6 and 2, without needing any higher frequency than the desired operational frequency of the IC chips.

## Claims

1. A clock generator comprising:

a PLL (Phase Lock Loop) circuit for generating an output clock signal by frequency-multiplying a reference clock signal;
a variable frequency divider (2) for obtaining the reference clock signal to be supplied to the PLL circuit by frequency-dividing an input clock signal; and
a control means for selectively controlling a frequency dividing ratio of the variable frequency divider (2).

2. A clock generator as recited in claim 1, said PLL circuit comprising:

a phase-frequency comparator (3) for comparing a frequency and a phase of a feedback signal to those of the reference clock signal;
an LPF (Low Pass Filter) (4) for extracting low frequency component from output of the phase-frequency comparator (3);
a VCO (Voltage Controlled Oscillator) (5) for generating the output clock signal of a frequency according to the output of the LPF (4); and
a frequency divider (6) for obtaining the feedback signal to be supplied to the phase-frequency comparator by frequency-dividing the output clock signal.

3. A clock generator as recited in claim 1, said control means comprising:

a frequency control register (7) for determining logic of frequency control signals for defining the frequency dividing ratio of the variable frequency divider (2); and
a means for controlling the frequency control register (7) according to desired operational speed of a circuit where the output clock signal is supplied.

4. A clock generator as recited in claim 1, said clock generator being configured in a semiconductor IC (Integrated Circuit), and said input clock signal being supplied from a crystal oscillator provided in the semiconductor IC.

5. A clock generator as recited in claim 1, said clock generator being configured in a semiconductor IC, and said input clock signal being supplied from an external circuit of the semiconductor IC.

EP 0 881 775 A1

## FIG.1

1: INPUT CLOCK TERMINAL

fr → FREQUENCY DIVIDER (2) → fd → PHASE-FREQUENCY COMPARATOR (3) → LPF (4) → VCO (5) → fv fc → 10: OUTPUT CLOCK TERMINAL

FREQUENCY CONTROL REGISTER (7) — 8, 9 → FREQUENCY DIVIDER (2)

FREQUENCY DIVIDER (6)

## FIG.2

FREQUENCY

fv=fc

fr

fr

fd

## FIG.3 PRIOR ART

1: INPUT CLOCK TERMINAL

fr → PHASE-FREQUENCY COMPARATOR (3) → LPF (4) → VCO (5)

FREQUENCY DIVIDER (6)

fv

FREQUENCY DIVIDER (2)

fd

CLOCK SELECTOR (12) → fc → 10: OUTPUT CLOCK TERMINAL

8
9
7
11

FREQUENCY CONTROL REGISTER

# FIG.4  PRIOR ART

**European Patent Office**

## EUROPEAN SEARCH REPORT

**Application Number**

EP 98 10 9540

### DOCUMENTS CONSIDERED TO BE RELEVANT

| Category | Citation of document with indication, where appropriate, of relevant passages | Relevant to claim | CLASSIFICATION OF THE APPLICATION (Int.Cl.6) |
|---|---|---|---|
| X | JP 08 044 465 A (SEIKO EPSON CORP) 16 February 1996<br>* the whole document *<br>& US 5 727 193 A (TAKEUCHI) 10 March 1998<br>* column 3, line 22 - column 5, line 8; figures 1,2 *<br>--- | 1-3 | H03L7/183<br>G06F1/08 |
| X | PATENT ABSTRACTS OF JAPAN<br>vol. 010, no. 005 (E-372), 10 January 1986<br>& JP 60 167525 A (HITACHI SEISAKUSHO KK), 30 August 1985<br>* abstract; figures *<br>--- | 1,2,4,5 | |
| X | PATENT ABSTRACTS OF JAPAN<br>vol. 018, no. 467 (E-1599), 30 August 1994<br>& JP 06 152392 A (NEC CORP), 31 May 1994<br>* abstract; figures *<br>--- | 1-3 | |
| X | US 5 142 247 A (LADA JR HENRY F ET AL) 25 August 1992<br>* column 2, line 3 - column 3, line 49 *<br>--- | 1-3,5 | TECHNICAL FIELDS SEARCHED (Int.Cl.6) |
| A,D | EP 0 766 404 A (NIPPON ELECTRIC CO) 2 April 1997<br>* column 3, line 30 - column 5, line 3; figure 2 *<br>* column 4, line 40 - column 6, line 65; figures 1,2 *<br>----- | 1-5 | H03L<br>G06F |

The present search report has been drawn up for all claims

| Place of search | Date of completion of the search | Examiner |
|---|---|---|
| THE HAGUE | 3 September 1998 | Balbinot, H |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)